# EUROPEAN PATENT APPLICATION

(11) **EP 1 965 615 A1**
(43) Date of publication of application: **03.09.2008**
(21) Application number: 06811275.4
(22) Date of filing: 05.10.2006
(51) Int. Cl.: H05K 1/14, H05K 3/46, H05K 9/00

(54) **MODULE HAVING BUILT-IN COMPONENT AND METHOD FOR FABRICATING SUCH MODULE**

(30) Priority: 22.12.2005 JP 2005369685
(71) Applicant: MURATA MANUFACTURING CO., LTD., Nagaokakyo-shi, Kyoto 617-8555 (JP)
(72) Inventor: NOMURA, Masato, Nagaokakyo-shi Kyoto, 617-8555 (JP); IEKI, Tsutomu, Nagaokakyo-shi Kyoto, 617-8555 (JP)
(74) Representative: Schoppe, Fritz
(86) International application number: PCT/JP2006/319937
(87) International publication number: WO 2007/072616

(57) **Abstract**

[Object] To provide a component-containing module capable of reducing cost and improving yield.

[Solving Means] A component-containing module A includes a module substrate 1 having first wiring lines 2 formed on the top surface of the module substrate; a first circuit component 7 mounted on the first wiring lines of the module substrate; a submodule substrate 10 having an area smaller than the area of the module substrate and mounted on the first wiring lines of the module substrate at a position where the first circuit component is not mounted; a second circuit component 15 mounted on second wiring lines 11 formed on the top surface of the submodule substrate; and an insulating resin layer 20 formed on the entire top surface of the module substrate so as to encompass the first circuit component, the second circuit component, and the submodule substrate. Application of a substrate having a wiring accuracy higher than that of the module substrate 1 to the submodule substrate 10 allows an integrated-circuit element 15a to be mounted on the submodule substrate, and realizes a highly reliable and low-cost component-containing module.

## Description

### Technical Field

The present invention relates to component-containing modules including a plurality of circuit components and methods for producing the same.

### Background Art

To date, component-containing modules including component-containing substrates, circuit components being embedded in insulating resin layers of the substrates, have been used for wireless devices such as cellular phones and automobile telephones and other various communication devices. As a component-containing module of this type, Patent Document 1 proposes a module including a plurality of circuit components disposed on a module substrate formed of a ceramic multilayer substrate and having an insulating resin layer formed on the entire top surface of the module substrate so as to encompass the circuit components.

Circuit components mounted on a module substrate include integrated-circuit elements such as semiconductor integrated circuit elements, and also include peripheral passive components such as filters and capacitors. In general, integrated-circuit elements have a large number of input-output terminals with narrow pitches, and thus a substrate on which the integrated-circuit elements are to be mounted needs to have a large number of accurately formed lands and wiring lines for connection with external circuits. On the other hand, passive components such as filters have a small number of terminals, and thus the dimensional accuracy of lands and wiring lines formed on a substrate on which the passive components are to be mounted can be low as compared with that of the substrate on which the integrated-circuit elements are to be mounted.

In the case of a component-containing module including one module substrate having both integrated-circuit elements and passive components, the dimensional accuracy of lands and wiring lines formed on the module substrate needs to correspond to that of the integrated-circuit elements. Therefore, the module substrate needs to have lands and wiring lines formed with high accuracy, resulting in an increase in cost.

Moreover, integrated-circuit elements such as BGAs (Ball Grid Arrays) and WLPs (Wafer Level Packages) having a large number of pins with narrow pitches are often flip-chip mounted on module substrates. In this case, it is difficult to confirm whether the mounting state (connecting state) is normal or not, and there is a high possibility that bad connections are found during testing after the completion of the modules. This leads to a reduction in yield.
Patent Document 1: Japanese Unexamined Patent Application Publication No. 2003-188538

### Disclosure of Invention

### Problems to be Solved by the Invention

Accordingly, an object of preferred embodiments of the present invention is to provide a highly reliable component-containing module capable of reducing costs and improving yield, and to provide a method for producing the same.

### Means of Solving the Problems

A component-containing module according to a first preferred embodiment of the present invention includes a module substrate having first wiring lines formed on the top surface of the module substrate; a first circuit component mounted on the first wiring lines of the module substrate; a submodule substrate having an area smaller than the area of the module substrate, having second wiring lines formed on the top surface of the submodule substrate, and mounted on the first wiring lines of the module substrate at a position where the first circuit component is not mounted; a second circuit component mounted on the second wiring lines of the submodule substrate; and an insulating resin layer formed on the entire top surface of the module substrate so as to encompass the first circuit component, the second circuit component, and the submodule substrate.

A component-containing module according to a second preferred embodiment of the present invention includes an insulating resin layer; first wiring lines formed on the bottom surface of the insulating resin layer; a first circuit component mounted on the first wiring lines and embedded in the insulating resin layer; a submodule substrate having an area smaller than the area of the insulating resin layer, having second wiring lines formed on the top surface of the submodule substrate, and embedded in the insulating resin layer at a position where the first circuit component is not embedded; and a second circuit component mounted on the second wiring lines of the submodule substrate and embedded in the insulating resin layer.

A method for producing the component-containing module according to the first preferred embodiment of the present invention includes the steps of preparing a module substrate having first wiring lines formed on the top surface of the module substrate; mounting a first circuit component on the first wiring lines of the module substrate; preparing a submodule substrate having an area smaller than the area of the module substrate and having second wiring lines formed on the top surface of the submodule substrate; mounting a second circuit component on the second wiring lines; mounting the submodule substrate, on which the second circuit component is mounted in advance, on the first wiring lines of the module substrate at a position where the first circuit component is not mounted; and forming an insulating resin layer on the entire top surface of the module substrate so as to encompass the first circuit component, the second circuit component, and the submodule substrate.

A method for producing the component-containing module according to the second preferred embodiment of the present invention includes the steps of forming first wiring lines on a supporting board; mounting a first circuit component on the first wiring lines; preparing a submodule substrate having second wiring lines formed on the top surface of the submodule substrate; mounting a second circuit component on the second wiring lines; placing the submodule substrate, on which the second circuit component is mounted in advance, on the supporting board at a position where the first circuit component is not mounted; forming an insulating resin layer on the top surface of the supporting board so as to encompass the first circuit component, the second circuit component, and the submodule substrate; and separating the insulating resin layer from the supporting board after the insulating resin layer has been cured.

The component-containing module according to the first preferred embodiment of the present invention will now be described. The first circuit component is mounted on the first wiring lines on the top surface of the module substrate, and the submodule substrate is mounted on the first wiring lines of the module substrate at a position where the first circuit component is not mounted. This submodule substrate has an area smaller than that of the module substrate, and has the second wiring lines formed on the top surface thereof. Moreover, the second circuit component is mounted on the second wiring lines of the submodule substrate. The insulating resin layer is formed on the entire top surface of the module substrate so as to encompass the first and second circuit components and the submodule substrate. In this manner, the component-containing module is configured. Herein, the first and second wiring lines include lands for mounting the circuit components and wiring lines for interconnecting the lands or for connecting the lands to other electrodes.

The insulating resin layer can be formed by, for example, bonding the insulating resin layer in a B stage (semicured) on the module substrate by pressing, and then curing the insulating resin layer. Alternatively, the insulating resin layer can be formed by molding insulating resin on the module substrate, and then curing the insulating resin layer. The insulating resin layer can be formed using any other methods. The insulating resin layer can ensure fixing between the module substrate and the submodule substrate, between the module substrate and the first circuit component, and between the submodule substrate and the second circuit component, and can also improve insulation between these components.

For example, when the first circuit component is a discrete component such as a filter and a capacitor having a small number of terminals and the second circuit component is an integrated-circuit element having a large number of terminals, a substrate having a high wiring accuracy (for example, a multilayer substrate) can be used for the submodule substrate on which the second circuit component is mounted, and a substrate having a relatively low wiring accuracy (for example, a monolithic substrate) can be used for the module substrate on which the first circuit component is mounted. Since the unit price per unit area of the substrate having a high wiring accuracy is higher than that of the substrate having a low wiring accuracy, the low-cost substrate is used for the module substrate. Although the cost per unit area of the submodule substrate is high, the entire cost can be reduced since the area of the submodule substrate is smaller than that of the module substrate.

Terminal electrodes to be connected to the first wiring lines of the module substrate are formed on the bottom surface of the submodule substrate. Appropriate connections of the wiring lines inside the submodule substrate can reduce the number of terminal electrodes as compared with the number of terminals of the integrated-circuit element mounted on the top surface of the submodule substrate, or can increase the intervals between the terminal electrodes as compared with that of the terminals of the integrated-circuit element. Thus, the submodule substrate having a high wiring accuracy can be mounted on the module substrate having a relatively low wiring accuracy.

When the second circuit component mounted on the submodule substrate is an integrated-circuit element that is to be flip-chip mounted, it is difficult to confirm the mounting state (connecting state) of the component, and a defect can be found during testing after the completion of the module. This leads to a reduction in yield. In contrast, according to the present invention, the second circuit component is mounted on the submodule substrate. Therefore, the connecting state of the second circuit component can be tested at the stage of the submodule substrate, and the connection can also be restored. Thus, a reduction in yield can be regulated.

The present invention is effective when the first circuit component includes circuit components taller than those included in the second circuit component. To date, semiconductor integrated-circuit packages used for portable devices and the like have changed from those of the known molded type to those having the flip-chip structure in which bumps are directly formed on silicon wafers, wafer level packages in which solder bumps are formed after re-routing, or the like, and the size and profile of the packages have been decreasing. Peripheral passive components such as filters and capacitors are often taller than such integrated-circuit elements. Accordingly, the second circuit component, which is shorter than the first circuit component, is mounted on the submodule substrate, and the first circuit component, which is taller than the second circuit component, is mounted on the module substrate such that the height of the first circuit component and the sum of the heights of the submodule substrate and the second circuit component are evened out. With this, a reduction in the height of the module can be realized.

The component-containing module can further include one or more submodule substrates, the submodule substrates being disposed with a spacing therebetween, and the first circuit component can be disposed at an intermediate position between an adjacent pair of the submodule substrates. In this case, the submodule substrates are disposed at either end of the module substrate, thereby improving the strength against warpage of the substrate and shock to the substrate.

It is preferable that the insulating resin layer has a shielding layer formed on the top surface thereof, that the first wiring lines or the second wiring lines include a ground electrode, and that a via conductor connecting the shielding layer and the ground electrode is formed in the insulating resin layer. In this case, a component-containing module having excellent shielding properties can be realized.

The component-containing module according to the second preferred embodiment of the present invention does not include a module substrate unlike the component-containing module according to the first embodiment, and the insulating resin layer itself functions as a substrate layer. The first wiring lines are formed on the bottom surface of the insulating resin layer, and the first circuit component mounted on the first wiring lines is embedded in the insulating resin layer. The submodule substrate having an area smaller than that of the insulating resin layer is embedded in the insulating resin layer at a position where the first circuit component is not embedded. The second circuit component is mounted on the second wiring lines formed on the top surface of the submodule substrate, and is also embedded in the insulating resin layer. Since the component-containing module does not include a module substrate, the height of the module can be further reduced. Although the mechanical strength of the module can be insufficient, the submodule substrate embedded in the insulating resin layer plays a role in reinforcing the insulating resin layer. Thus, occurrence of warpage or the like can be prevented.

### Effects of Preferred Embodiments of the Invention

According to the component-containing module of the present invention, the first circuit component and the submodule substrate on which the second circuit component is mounted are mounted on the module substrate as described above. That is, the first circuit component and the second circuit component are separately mounted on substrates having optimal wiring accuracies for the corresponding circuit components. In particular, when an integrated-circuit element is used as the second circuit component, a substrate having a high wiring accuracy is used for the submodule substrate. With this, a highly reliable module can be realized, and the cost can be reduced as compared with the case where a substrate having a high wiring accuracy is used for the entire module substrate. Moreover, testing can be conducted when the second circuit component is mounted on the submodule substrate, thereby improving yield as compared with the case where testing is conducted after the completion of the module.

### Best Mode for Carrying Out the Invention

Embodiments of the present invention will now be described with reference to examples.

### EXAMPLE 1

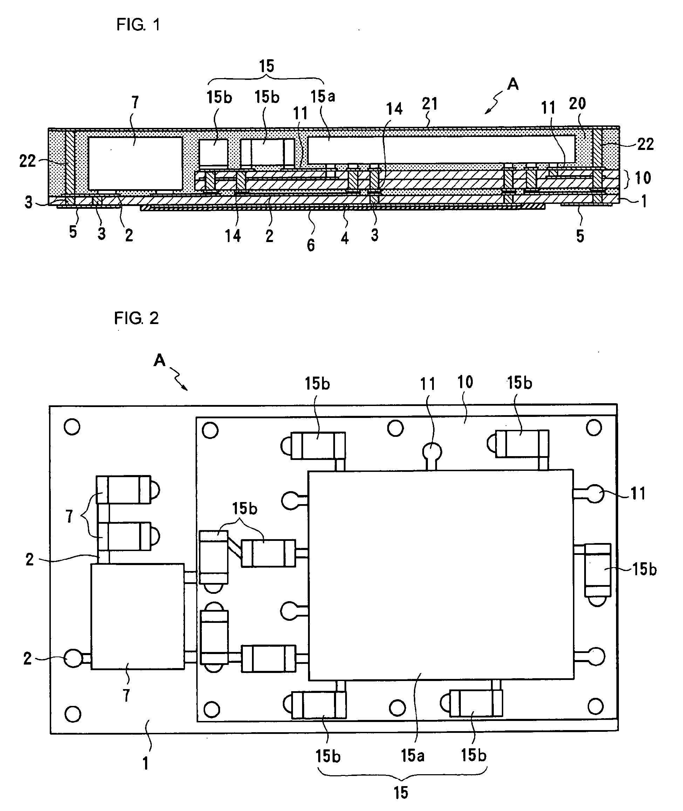

Figs. 1 to 3(e) illustrate a component-containing module according to a first example of the present invention. Fig. 1, Fig. 2, and Figs. 3(a) to 3(e) are a cross-sectional view, a plan view without an insulating resin layer, and cross-sectional views illustrating a production process of the module, respectively.

A component-containing module A includes a module substrate 1 formed of an insulated substrate such as a resin substrate. As shown in Fig. 1, a plurality of wiring electrodes 2 are formed on the top surface of the module substrate 1, and are connected to a shielding electrode 4 and terminal electrodes 5 on the bottom surface of the module substrate 1 through via conductors 3. Herein, the module substrate 1 is of the monolithic type, but can be of the multilayer type. The shielding electrode 4 is formed at a central portion on the bottom surface of the module substrate 1, and the terminal electrodes 5 are disposed around the shielding electrode 4 so as to surround the shielding electrode 4. The shielding electrode 4 is covered with a solder resist film 6. First circuit components 7 including discrete passive components such as filters and capacitors are mounted on the wiring electrodes 2 formed on the top surface of the module substrate 1. The first circuit components 7 include components taller than those included in second circuit components 15 (described below).

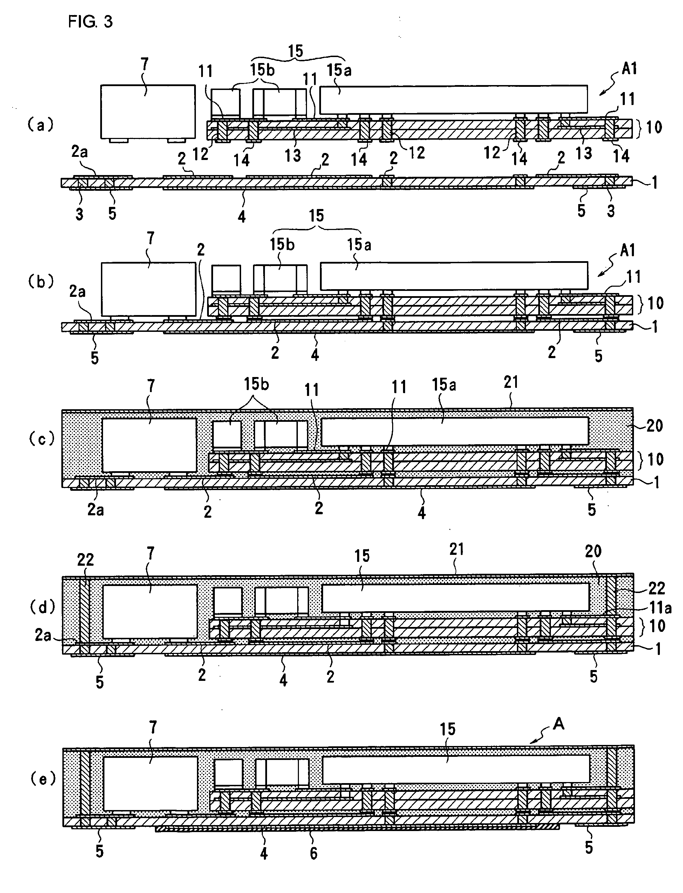

A submodule A1 is mounted on the module substrate 1 in an area where the first circuit components 7 are not mounted. The submodule A1 includes a submodule substrate 10 having an area smaller than that of the module substrate 1, and the second circuit components 15 mounted on the top surface of the submodule substrate 10. The submodule substrate 10 is of the multilayer type formed of, for example, a resin multilayer substrate or a ceramic multilayer substrate. A plurality of wiring electrodes 11 are formed on the top surface of the submodule substrate 10, and connected to internal electrodes 13 and terminal electrodes 14 formed on the bottom surface of the submodule substrate 10 through via conductors 12 (see Fig. 3(a)). The second circuit components 15 including an integrated-circuit element 15a and discrete passive components 15b are mounted on the wiring electrodes 11. Herein, the discrete passive components 15b are mounted on the wiring electrodes 11 in addition to the integrated-circuit element 15a. However, only the integrated-circuit element 15a can be mounted on the wiring electrodes 11. The integrated-circuit element 15a has a large number of terminals on the bottom surface thereof, and is flip-chip mounted on the wiring electrodes 11. Due to appropriate wiring connections inside the submodule substrate 10, the number of terminal electrodes 14 formed on the bottom surface of the submodule substrate 10 is reduced as compared with the number of lands of the wiring electrodes 11 formed on the top surface of the submodule substrate 10, or the intervals between the terminal electrodes are increased. The terminal electrodes 14 of the submodule substrate 10 are mounted on the wiring electrodes 2 of the module substrate 1 using, for example, solder balls, solder paste, and an electrically conductive adhesive.

As described above, the integrated-circuit element 15a and the discrete passive components 7 are separately mounted on the submodule substrate 10 and the module substrate 1, respectively, and a substrate having a wiring accuracy higher than that of the module substrate 1 is used for the submodule substrate 10. That is, the submodule substrate 10 is manufactured on the basis of a rigorous design rule as compared with that of the module substrate 1, and thus the unit price per unit area of the submodule substrate 10 becomes higher than that of the module substrate 1. However, the production cost can be reduced as compared with the case where the entire module substrate 1 is formed of a substrate having a high wiring accuracy since the submodule substrate 10 is smaller than the module substrate 1.

It is preferable that a material having a thermal expansion coefficient close to that of the integrated-circuit element 15a is used for the submodule substrate 10, and that a material having a thermal expansion coefficient that is intermediate between that of the submodule substrate 10 and that of a motherboard on which the component-containing module A is to be mounted is used for the module substrate 1. In this case, the difference in the thermal expansion coefficients between the integrated-circuit element 15a and the motherboard can be reduced using the module substrate 1 and the submodule substrate 10, and problems such as exfoliation of the electrodes (terminals) as a result of temperature changes can be solved. It is preferable that a material having the intermediate thermal expansion coefficient is used for an insulating resin layer 20 (described below) as in the module substrate 1.

The insulating resin layer 20 is formed on the entire top surface of the module substrate 1, and the first circuit components 7, the second circuit components 15, and the submodule substrate 10 are embedded in the insulating resin layer 20. In Fig. 2, one of the side surfaces of the submodule substrate 10 is exposed at a side surface of the insulating resin layer 20. However, the side surface of the submodule substrate 10 does not need to be exposed. The insulating resin layer 20 is composed of, for example, a thermosetting resin, or a resin composite composed of a mixture of a thermosetting resin and an inorganic filler. The insulating resin layer 20 has a function of increasing the fixing strengths between the module substrate 1 and the submodule substrate 10, between the module substrate 1 and the first circuit components 7, and between the submodule substrate 10 and the second circuit components 15, and at the same time, has a function of improving the insulation between these components. A shielding layer 21 composed of copper foil or the like is formed on the top surface of the insulating resin layer 20. The wiring electrodes 2 of the module substrate 1 and the wiring electrodes 11 of the submodule substrate 10 include ground electrodes 2a and 11a, respectively, and these ground electrodes 2a and 11a are connected to the shielding layer 21 through via conductors 22 formed in the insulating resin layer 20. The ground electrodes 2a and 11a are connected to the terminal electrodes 5 (for grounding) on the bottom surface of the module substrate 1 through the via conductors 3 and 12, respectively. Thus, the shielding layer 21 can be reliably maintained at a ground potential.

Next, an example of a method for producing the component-containing module having the above-described structure will be described with reference to Figs. 3(a) to 3(e). Fig. 3(a) illustrates a state where the module substrate 1 and the submodule A1 are prepared. The submodule A1 includes the second circuit components 15 mounted on the submodule substrate 10 in advance. Herein, the module substrate 1 will be described as a daughterboard. However, the module substrate 1 is practically a collective board including a plurality of daughterboards.

Fig. 3(b) illustrates a state where the submodule A1 is mounted on the wiring electrodes 2 of the module substrate 1, and at the same time, the first circuit components 7 are mounted adjacent to the submodule A1. The mounting method can include reflow soldering, flip-chip mounting using bumps, and mounting using electrically conductive adhesives. The height of the first circuit components 7 including components taller than those included in the second circuit components 15 and the height of the submodule A1 (the sum of the heights of the submodule substrate 10 and the second circuit components 15) are evened out such that the height of the entire module is reduced. The gap formed between the module substrate 1 and the submodule substrate 10 can be filled with underfill resin, solder resist, or the like.

Fig. 3(c) illustrates a state where the insulating resin layer 20 is formed on the entire top surface of the module substrate 1 so as to encompass the submodule A1 and the first circuit components 7, and the shielding layer 21 is formed on the top surface of the insulating resin layer 20. The insulating resin layer 20 is formed on the entire surface of the module substrate 1, which is a collective board at this moment. The insulating resin layer 20 and the shielding layer 21 can be formed by, for example, placing copper foil serving as the shielding layer 21 on the top surface of the insulating resin layer 20 in a B stage (semicured), bonding the insulating resin layer on the module substrate 1 by pressing, and then curing the insulating resin layer. Moreover, the insulating resin layer 20 and the shielding layer 21 can be formed by molding insulating resin on the module substrate 1 and then forming the shielding layer 21 on the top surface of the insulating resin layer 20 using electroless plating or the like after the insulating resin layer has been cured. The insulating resin layer 20 and the shielding layer 21 can be formed using any other methods.

Fig. 3(d) illustrates a state where through-holes communicating with the ground electrode 2a that is formed on the top surface of the module substrate 1 and the ground electrode 11a that is formed on the top surface of the submodule substrate 10 are formed in the insulating resin layer 20, and are filled with a conductor such as an electrically conductive adhesive, which forms the via conductors 22 connected to the shielding layer 21 after the conductor has been cured. The through-holes are formed using punching, drilling, laser processing, or the like. The via conductors 22 are not necessarily filled with the conductor, and can be through-holes each having an electrode film formed on the inner surface thereof using electroless plating or the like and connected to the shielding layer 21.

Fig. 3(e) illustrates a state where the solder resist film 6 is formed so as to cover the shielding electrode 4 formed at the central portion on the bottom surface of the module substrate 1. This solder resist film 6 prevents the shielding electrode 4 from coming into contact with electrodes on the motherboard, the electrodes not being at the ground potential, when the component-containing module A is mounted on the motherboard. Subsequently, the module substrate 1, which is a collective board at this moment, and the insulating resin layer 20 are divided into daughterboards so as to form separate component-containing modules A.

Since the integrated-circuit element 15a including a large number of terminals are flip-chip mounted on the submodule substrate 10 as described above, it is difficult to confirm the mounting state (connecting state) from outward appearances, and thus electrical testing is required. The testing can be conducted after the submodule A1 is mounted on the module substrate 1. However, the entire module needs to be discarded when a defect is found. In contrast, according to the production method shown in Figs. 3(a) to 3(e), the integrated-circuit element 15a is mounted on the submodule substrate 10 in advance, and then this submodule A1 is mounted on the module substrate 1. Accordingly, the connecting state of the integrated-circuit element 15a can be tested at the stage of the submodule A1. More specifically, electrical characteristics of the integrated-circuit element 15a are measured by using the terminal electrodes 14 of the submodule substrate 10. If a defect is found at this moment, the integrated-circuit element 15a can be removed from the submodule substrate 10, and can be mounted again. With this, the yield can be improved.

### EXAMPLE 2

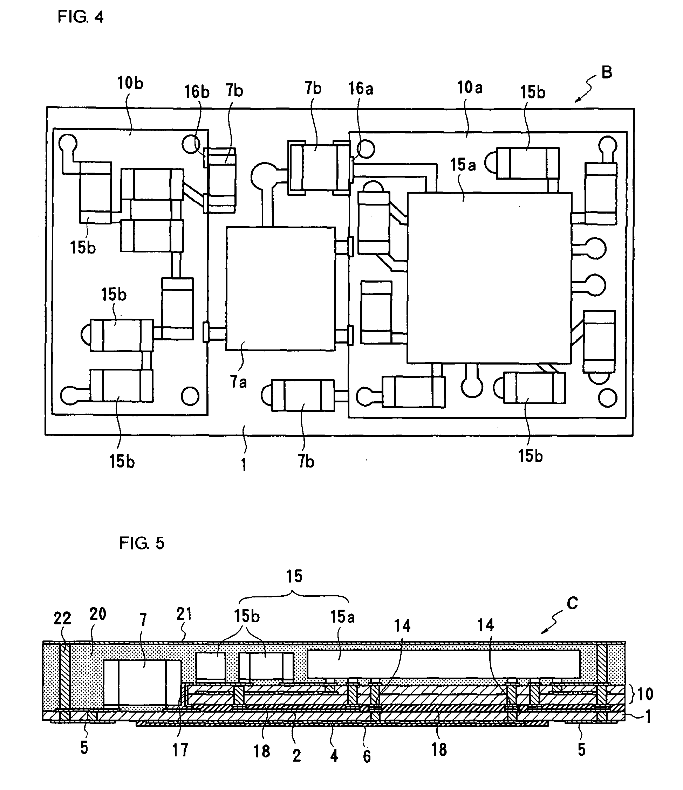

Fig. 4 is a plan view of a component-containing module according to a second example without an insulating resin layer. The same reference numerals are used for components corresponding to those in the first example, and the descriptions thereof will be omitted.

In this component-containing module B, two submodule substrates 10a and 10b are mounted on a module substrate 1 so as to have a space therebetween, and a first circuit component 7a taller than second circuit components 15 is mounted on the module substrate 1 in the space between the submodule substrates 10a and 10b. An integrated-circuit element 15a and discrete passive components 15b are mounted on the submodule substrate 10a, whereas only the discrete passive components 15b are mounted on the submodule substrate 10b. In this example, first circuit components 7b that are relatively short are also mounted on the module substrate 1 in the space between the submodule substrates 10a and 10b, and some of the first circuit components 7b are connected to terminal electrodes 16a and 16b formed on side surfaces of the submodule substrates 10a and 10b, respectively. Thus, the connecting state can be easily confirmed.

In this example, two submodule substrates 10a and 10b are mounted on one module substrate 1 in a longitudinal direction of the module substrate. Therefore, both ends of the module substrate 1 in the longitudinal direction can be balanced, and the degree of warpage of the module substrate 1 can be reduced. In the above-described example, the integrated-circuit element 15a is mounted only on the submodule substrate 10a. However, integrated-circuit elements can be mounted on both the submodule substrates 10a and 10b.

### EXAMPLE 3

Fig. 5 illustrates a component-containing module according to a third example. The same reference numerals are used for components corresponding to those in the first example, and the descriptions thereof will be omitted. In this component-containing module C, terminal electrodes 17 are formed on a side surface of a submodule substrate 10, and are connected to first circuit components 7 using solder or an electrically conductive adhesive. In this case, the connecting state can be confirmed from outward appearances, and thus the occurrence of poor electrical connection can be reduced. Moreover, solder resist films 18 formed in spaces between the terminal electrodes 14 disposed on the bottom surface of the submodule substrate 10 can regulate short-circuits between the electrodes and outflow of the solder.

The connecting state of the terminal electrodes 14 with the module substrate 1 can also be easily confirmed in a similar manner as the terminal electrode 17 by forming the terminal electrodes 14 of the submodule substrate 10 so as to extend from the bottom surface to the side surface of the submodule substrate 10.

### EXAMPLE 4

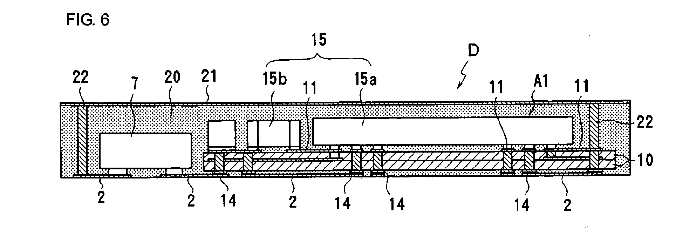

Figs. 6 to 7(e) illustrate a component-containing module according to a fourth example. The same reference numerals are used for components corresponding to those in the first example, and the descriptions thereof will be omitted. In this component-containing module D, the module substrate 1 used in the first example is omitted, and an insulating resin layer 20 constitutes a substrate body. That is, wiring electrodes 2 are formed on the bottom surface of the insulating resin layer 20, and first circuit components 7 and a submodule A1 are mounted on the wiring electrodes 2. As in the first example, the submodule A1 includes a submodule substrate 10 and second circuit components 15 mounted on the submodule substrate 10. The wiring electrodes 2 exposed at the bottom surface of the component-containing module D serve as terminal electrodes to be connected to a motherboard or the like.

In this example, the height of the entire component-containing module D can be made small since the component-containing module D does not include the module substrate 1. Due to the absence of the module substrate 1, the mechanical strength of the component-containing module D can be reduced. However, the submodule substrate 10 embedded in the insulating resin layer 20 functions as a reinforcing material, and prevents warpage or bending of the component-containing module D.

In this example, all the terminal electrodes 14 of the submodule substrate 10 are mounted on the wiring electrodes 2. However, only parts of the terminal electrodes 14 can be mounted on the wiring electrodes 2, and the wiring electrodes 2 under the submodule substrate 10 can be partly omitted such that the rest of the terminal electrodes 14 formed on the bottom surface of the submodule substrate 10 are exposed at the bottom surface of the insulating resin layer 20.

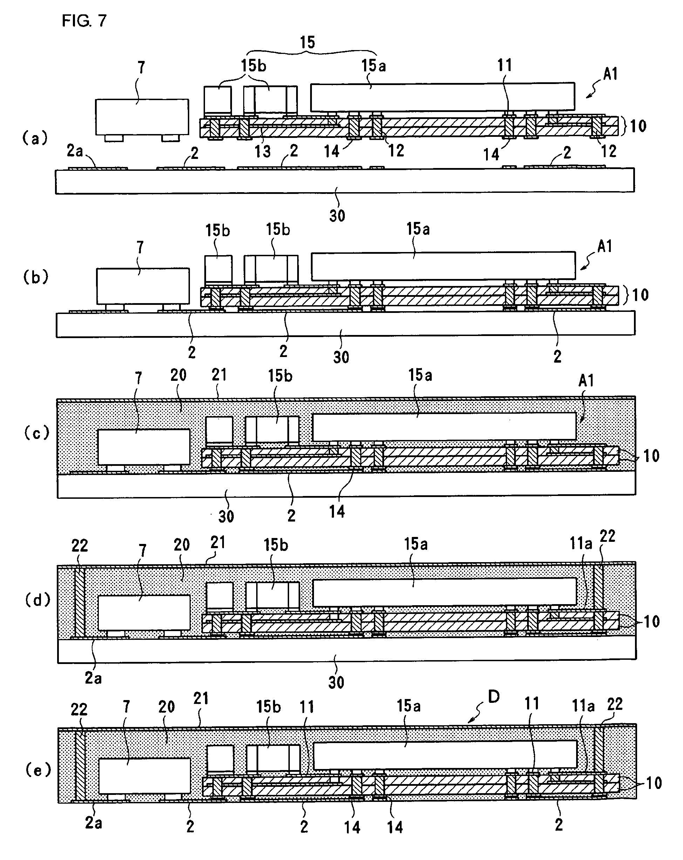

Figs. 7(a) to 7(e) illustrate a production process of the component-containing module D. In Figs. 7(a) to 7(e), a production process of a single module is shown. However, modules are practically produced from a collective board, and are divided into daughterboards at the final stage.

Fig. 7(a) illustrates a state where a supporting board 30 having the wiring electrodes 2 formed on the top surface thereof by patterning metallic foil, the submodule A1, and the first circuit components 7 are prepared.

Fig. 7(b) illustrates a state where the submodule A1 and the first circuit components 7 are mounted on the wiring electrodes 2 on the supporting board 30. The mounting method can include reflow soldering, flip-chip mounting using bumps, and mounting using electrically conductive adhesives.

Fig. 7(c) illustrates a state where the insulating resin layer 20 is formed on the entire top surface of the supporting board 30 so as to encompass the submodule A1 and the first circuit components 7, and a shielding layer 21 is formed on the top surface of the insulating resin layer 20. More specifically, the insulating resin layer 20 in a B stage (semicured) having copper foil serving as the shielding layer 21 placed on the top surface thereof is bonded on the supporting board 30 by pressing, and then cured.

Fig. 7(d) illustrates a state where through-holes communicating with a ground electrode 2a that is formed on the top surface of the supporting board 30 and a ground electrode 11a that is formed on the top surface of the submodule substrate 10 are formed in the insulating resin layer 20, and are filled with, for example, an electrically conductive adhesive, which forms via conductors 22 connected to the shielding layer 21 after the adhesive has been cured.

Fig. 7(e) illustrates a state where the cured insulating resin layer 20 is separated from the supporting board 30. With this, the component-containing module D is completed.

### Brief Description of the Drawings

Fig. 1 is a cross-sectional view of a component-containing module according to a first example of the present invention.
Fig. 2 is a plan view of the component-containing module shown in Fig. 1 without an insulating resin layer.
Figs. 3(a) to 3(e) are cross-sectional views illustrating a production process of the component-containing module shown in Fig. 1.
Fig. 4 is a plan view of a component-containing module according to a second example of the present invention without an insulating resin layer.
Fig. 5 is a cross-sectional view of a component-containing module according to a third example of the present invention.
Fig. 6 is a cross-sectional view of a component-containing module according to a fourth example of the present invention.
Figs. 7(a) to 7(e) illustrate a production process of the component-containing module shown in Fig. 6.

### Reference Numerals

- A to D: component-containing modules
- A1: submodule
- 1: module substrate
- 2: wiring electrodes (first wiring lines)
- 3: via conductors
- 4: shielding electrode
- 5: terminal electrodes
- 7: first circuit components
- 10: submodule substrate
- 11: wiring electrodes (second wiring lines)
- 12: via conductors
- 13: internal conductors
- 14: terminal electrodes
- 15: second circuit components
- 15a: integrated-circuit element
- 15b: discrete passive components
- 20: insulating resin layer
- 21: shielding layer
- 22: via conductors
- 30: supporting board

## Claims

1. A component-containing module comprising:
a module substrate having first wiring lines formed on the top surface of the module substrate;
a first circuit component mounted on the first wiring lines of the module substrate;
a submodule substrate having an area smaller than the area of the module substrate, having second wiring lines formed on the top surface of the submodule substrate, and mounted on the first wiring lines of the module substrate at a position where the first circuit component is not mounted;
a second circuit component mounted on the second wiring lines of the submodule substrate; and
an insulating resin layer formed on the entire top surface of the module substrate so as to encompass the first circuit component, the second circuit component, and the submodule substrate.

2. A component-containing module comprising:
an insulating resin layer;
first wiring lines formed on the bottom surface of the insulating resin layer;
a first circuit component mounted on the first wiring lines and embedded in the insulating resin layer;
a submodule substrate having an area smaller than the area of the insulating resin layer, having second wiring lines formed on the top surface of the submodule substrate, and embedded in the insulating resin layer at a position where the first circuit component is not embedded; and
a second circuit component mounted on the second wiring lines of the submodule substrate and embedded in the insulating resin layer.

3. The component-containing module according to Claim 1 or 2, wherein
the second circuit component includes an integrated-circuit element having a large number of terminals;
the terminals of the integrated-circuit element are connected and fixed to the corresponding second wiring lines of the submodule substrate; and
terminal electrodes to be connected and fixed to the first wiring lines are formed on the bottom surface of the submodule substrate.

4. The component-containing module according to Claim 3, wherein the first circuit component is a discrete circuit component having fewer terminals than the integrated-circuit element.

5. The component-containing module according to any one of Claims 1 to 4, wherein the first circuit component includes a circuit component taller than the second circuit component.

6. The component-containing module according to any one of Claims 1 to 5, wherein
the component-containing module further comprises one or more submodule substrates, the submodule substrates being disposed with a spacing therebetween; and
the first circuit component is disposed at an intermediate position between an adjacent pair of the submodule substrates.

7. The component-containing module according to any one of Claims 1 to 6, wherein
the insulating resin layer has a shielding layer formed on the top surface of the insulating resin layer;
the first wiring lines or the second wiring lines include a ground electrode; and
a via conductor connecting the shielding layer and the ground electrode is formed in the insulating resin layer.

8. A method for producing a component-containing module, comprising the steps of:
preparing a module substrate having first wiring lines formed on the top surface of the module substrate;
mounting a first circuit component on the first wiring lines of the module substrate;
preparing a submodule substrate having an area smaller than the area of the module substrate and having second wiring lines formed on the top surface of the submodule substrate;
mounting a second circuit component on the second wiring lines;
mounting the submodule substrate, on which the second circuit component is mounted in advance, on the first wiring lines of the module substrate at a position where the first circuit component is not mounted; and
forming an insulating resin layer on the entire top surface of the module substrate so as to encompass the first circuit component, the second circuit component, and the submodule substrate.

9. A method for producing a component-containing module, comprising the steps of:
forming first wiring lines on a supporting board;
mounting a first circuit component on the first wiring lines;
preparing a submodule substrate having second wiring lines formed on the top surface of the submodule substrate;
mounting a second circuit component on the second wiring lines;
placing the submodule substrate, on which the second circuit component is mounted in advance, on the supporting board at a position where the first circuit component is not mounted;
forming an insulating resin layer on the top surface of the supporting board so as to encompass the first circuit component, the second circuit component, and the submodule substrate; and
separating the insulating resin layer from the supporting board after the insulating resin layer has been cured.
